# EUROPÄISCHE PATENTSCHRIFT

(11) **EP 0 709 817 B1**
(45) Veröffentlichungstag und Bekanntmachung des Hinweises auf die Patenterteilung: **29.04.1998**
(21) Anmeldenummer: 95113743.9
(22) Anmeldetag: 01.09.1995
(51) Int. Cl.: G09F 7/06

(54) **Bezeichnungsschild zur Verrastung in elektrisch/elektronischen Bauelementen**
Marking tag to be fastened to an electrical or electronical component by snap-fitting
Panneau de marquage destiné à être fixé sur un élément de construction électrique ou électronique

(30) Priorität: 29.10.1994 DE 9417391 U
(43) Veröffentlichungstag der Anmeldung: 01.05.1996
(73) Patentinhaber: Weidmüller Interface GmbH & Co., D-32760 Detmold (DE)
(72) Erfinder: Blanke, Uwe, D-32760 Detmold (DE); Wieneke, Andreas, D-32657 Lemgo (DE)
(74) Vertreter: Stracke, Alexander, Dipl.-Ing.

(56) Entgegenhaltungen:
- EP-A- 0 086 572
- DE-C- 3 932 066
- FR-A- 2 629 527

## Beschreibung

Die Erfindung betrifft ein Bezeichnungsschild mit einer Bezeichnungsträgerplatte und darunter angeordneten Rastelementen zur Verrastung in zueinander parallelen Rastkanälen elektrisch/elektronischer Bauelemente. Derartige Bezeichnungsschilder zur Kennzeichnung elektrischer oder elektronischer Bauelemente sind in vielen Ausführungsvarianten handelsüblich. In den Kunststoffgehäusen der elektrischen oder elektronischen Bauelemente, insbesondere in den Kunststoffgehäusen beispielsweise von Reihenklemmen, befinden sich zueinander parallele Rastkanäle, in die zu Kennzeichnungszwecken Bezeichnungsschilder verrastend eingedrückt werden können. Bei den bislang bekannten Bezeichnungsschildern bestehen die Rastelemente für jedes Bezeichnungsschild aus zwei zueinander parallelen kleinen Raststegen auf der Unterseite der Bezeichnungsträgerplatte, die in die parallelen Kanäle eingedrückt werden.

Es besteht das Problem, daß unterschiedliche Rastsysteme vorhanden sind, insbesondere insoweit, als die Rastkanäle an elektrischen/ elektronischen Bauelementen in unterschiedlichen, um 90° zueinander versetzten Raumlagen orientiert sind. Die Abstände der parallelen Rastkanäle weichen in den beiden unterschiedlich orientierten Rastkanalsystemen auch voneinander ab. Demzufolge müssen Bezeichnungsschilder hergestellt oder bevorratet werden, die entweder nur für das eine oder für das andere Rastsystem geeignet sind.

Der vorliegenden Erfindung liegt von daher die Aufgabe zugrunde, ein Bezeichnungsschild zu schaffen, das universell für die bekannten Rastsysteme geeignet ist.

Die erfindungsgemäße Lösung besteht darin, daß die Rastelemente eines Bezeichnungsschildes aus vier Rastbeinen bestehen und jedes Rastbein zwei um 90° zueinander versetzte Rastkonturen aufweist.

Dank dieser Ausgestaltung ist gewährleistet, daß in jedem Fall für die zwei parallelen, von Rastsystem zu Rastsystem um 90° zueinander versetzt orientierten Rastkanäle der elektrischen/elektronischen Bauelemente alle vier Rastbeine jeweils eine Rastkontur an passender Stelle haben, also in jedes Rastsystem jeweils zwei Rastbeinpaare mit entsprechender Rastkontur in die Kanäle eingerastet werden können.

In zweckmäßiger Ausgestaltung haben die vier Rastbeine jeweils paarweise einen unterschiedlichen Abstand voneinander, so daß ihre Rastkonturen jeweils paarweise passend für die Verrastung unter Berücksichtigung des jeweiligen Abstandes der Rastkanäle voneinander bei den beiden Rastsystemen sind.

Die Herstellung derartiger Bezeichnungsschilder ist damit erheblich vereinfacht. Das gilt auch für die Bevorratung, die besonders anwenderfreundlich ist, da für die unterschiedlichen Bezeichnungsschilderrastsysteme insbesondere auch unterschiedlicher Hersteller derartiger elektrisch/elektronischer Bauelemente nur noch ein insoweit universell einsetzbares Bezeichnungsschildsystem benötigt wird.

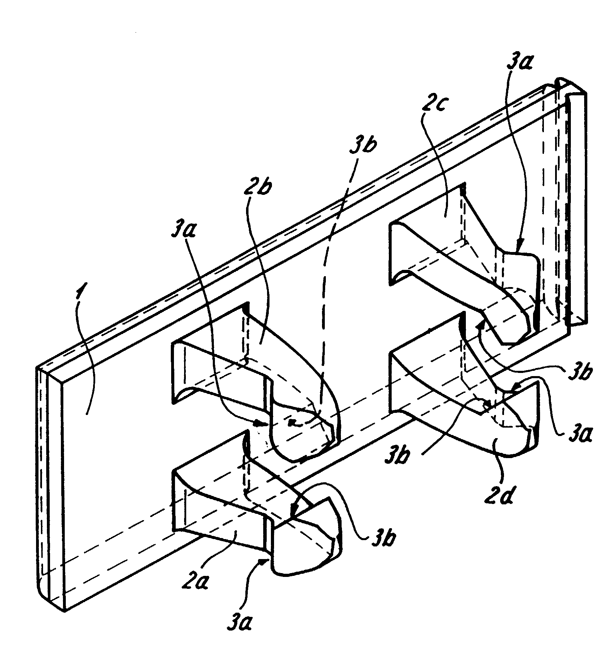

Ein Ausführungsbeispiel eines derartigen Bezeichnungsschildes wird nachstehend unter Bezugnahme auf die Zeichnung näher beschrieben.

Die Zeichnung zeigt in Perspektive und Unteransicht ein Bezeichnungsschild gemäß der Erfindung.

Das Bezeichnungsschild hat eine Bezeichnungsträgerplatte 1, auf der sich oberseitig die Bezeichnung befindet. Es ist in der üblichen Weise jede Art von Beschriftungstechnik, einschließlich der Beschriftung auf Plottern, durchzuführen.

An der Unterseite der Bezeichnungsträgerplatte 1 befinden sich Rastelemente zur Verrastung in zueinander parallelen Rastkanälen elektrisch/elektronischer Bauelemente. Erfindungsgemäß bestehen die Rastelemente eines Bezeichnungsschildes aus vier einzelnen Rastbeinen 2a, 2b, 2c, 2d. Jedes der vier Rastbeine 2a - 2d hat zwei um 90° zueinander versetzt angeordnete Rastkonturen 3a, 3b zur Verrastung mit entsprechenden Rastkonturen der Rastkanäle der elektrisch/elektronischen Bauelemente.

Dank dieser Ausgestaltung stehen zur Verrastung mit den beiden um 90° raumorientiert versetzt zueinander verlaufenden Rastkanälen der unterschiedlichen Rastsysteme immer insgesamt vier Rastkonturen 3a, 3b der insoweit dann paarweise mit den Rastkanälen zusammenwirkenden Rastbeine 2a - 2d zur Verfügung.

Wie aus der Figur ersichtlich, haben die Rastbeinpaare 2a und 2b sowie 2c und 2d innerhalb dieser Paargruppen einen kleineren Abstand voneinander als die Rastbeine in der Paarkombination 2a und 2d sowie 2b und 2c. Dies ist auf die unterschiedlichen Abstände der parallelen Rastkanäle der unterschiedlichen Rastsysteme ausgelegt.

Bei Einrastung eines derartigen Bezeichnungsschildes in das eine Rastkanalsystem, also beispielsweise das mit dem geringeren Abstand der Rastkanäle voneinander, wirken mit diesen Rastkanälen paarweise die Rastbeine 2a und 2b mit ihren innenseitig liegenden, einander zugewandt liegenden Rastkonturen 3b sowie das Beinpaar 2c und 2d mit den entsprechendne Rastkonturen 3b zusammen.

Bei Verwendung mit dem um 90° versetzt dazu orientierten Rastkanalsystem, bei dem die Rastkanäle voneinander einen größeren Abstand haben, wirken dann paarweise die Rastbeine 2a und 2d mit ihren insoweit außen liegenden Rastkonturen 3a und dem Rastbeinpaar 2b und 2c ebenfalls mit den entsprechenden außen liegenden Rastkonturen 3a zusammen.

## Patentansprüche

1. Bezeichnungsschild mit einer Bezeichnungsträgerplatte und darunter angeordneten Rastelementen zur Verrastung in zueinander parallelen Rastkanälen elektrisch/elektronischer Bauelemente, **dadurch gekennzeichnet**, daß die Rastelemente eines Bezeichnungsschildes aus vier Rastbeinen (2a, 2b, 2c, 2d) bestehen und jedes Rastbein zwei um 90° zueinander versetzte Rastkonturen (3a, 3b) aufweist.

2. Bezeichnungsschild nach Anspruch 1, dadurch gekennzeichnet, daß die Rastbeine (2a, 2b, 2c, 2d) paarweise angeordnet und paarweise (2a und 2b, 2c und 2d; 2a und 2d, 2b und 2c) um 90° zueinander versetzt unterschiedliche Abstände aufweisen.

3. Bezeichnungsschild nach einem der vorhergehenden Ansprüche, dadurch gekennzeichnet, daß die in größerem Abstand zueinander angeordneten Rastbeinpaare (2a und 2d; 2b und 2c) ihre zusammenwirkenden Rastkonturen (3a) außenseitig haben.

4. Bezeichnungsschild nach einem der vorhergehenen Ansprüche, dadurch gekennzeichnet, daß die in geringerem Abstand zueinander angeordneten Rastbeinpaare (2a und 2b; 2c und 2d) ihre zusammenwirkenden Rastkonturen (3b) auf einander zugewandten Innenseiten haben.

## Claims

1. An identification plate comprising an identification carrier plate portion and latching elements arranged therebeneath for latching in mutually parallel latching passages in electrical/electronic components, characterised in that the latching elements of an identification plate comprise four latching legs (2a, 2b, 2c, 2d) and each latching leg has two latching contours (3a, 3b) which are displaced through 90° relative to each other.

2. An identification plate according to claim 1 characterised in that the latching legs (2a, 2b, 2c, 2d) are arranged in pairs and are at different spacings in displaced relationship to each other through 90° in pairs (2a and 2b, 2c and 2d; 2a and 2d, 2b and 2c).

3. An identification plate according to one of the preceding claims characterised in that the pairs of latching legs (2a and 2d; 2b and 2c) which are arranged at a greater spacing relative to each other have their co-operating latching contours (3a) on the outside.

4. An identification plate according to one of the preceding claims characterised in that the pairs of latching legs (2a and 2b; 2c and 2d) which are arranged at a smaller spacing relative to each other have their co-operating latching contours (3b) on mutually facing inward sides.

## Revendications

1. Etiquette de repérage comportant une plaque de support de repérage et des éléments d'encliquetage, situés au-dessous, pour l'encliquetage dans des canaux d'encliquetage, parallèles entre eux, de composants électriques/électroniques, caractérisée en ce que les éléments d'encliquetage d'une étiquette de repérage sont constitués de quatre jambes d'encliquetage (2a, 2b, 2c, 2d) et chaque jambe d'encliquetage présente deux contours d'encliquetage (3a, 3b), décalés entre eux de 90°.

2. Etiquette de repérage selon la revendication 1, caractérisée en ce que les jambes d'encliquetage (2a, 2b, 2c, 2d) sont disposées deux par deux et présentent deux par deux (2a et 2b, 2c et 2d ; 2a et 2d, 2b et 2c) des distances différentes, décalées entre elles de 90°.

3. Etiquette de repérage selon l'une des revendications précédentes, caractérisée en ce que les paires de jambes d'encliquetage (2a et 2d ; 2b et 2c) disposées suivant un plus grand écartement l'une de l'autre, possèdent sur leur côté extérieur des contours d'encliquetage (3a) coopérants.

4. Etiquette de repérage selon l'une des revendications précédentes, caractérisée en ce que les paires de jambes d'encliquetage (2a et 2b ; 2c et 2d), disposées suivant un plus petit écartement, possèdent leurs contours d'encliquetage (3b) coopérants sur des côtés intérieurs tournés l'un vers l'autre.
